# EUROPÄISCHE PATENTSCHRIFT

(11) **EP 1 871 145 B1**
(45) Veröffentlichungstag und Bekanntmachung des Hinweises auf die Patenterteilung: **19.10.2011**
(21) Anmeldenummer: 07011983.9
(22) Anmeldetag: 19.06.2007
(51) Int. Cl.: H05B 33/08, H03K 17/96

(54) **Leuchtensystem**
Illumination system
Système d'éclairage

(30) Priorität: 19.06.2006 DE 102006028074
(43) Veröffentlichungstag der Anmeldung: 26.12.2007
(73) Patentinhaber: Münchner Hybrid Systemtechnik GmbH, 80339 München (DE)
(72) Erfinder: Rudrich, Hans-Peter, 86926 Greifenberg (DE)
(74) Vertreter: Liesegang, Eva

(56) Entgegenhaltungen:
- EP-A- 1 383 242
- EP-A2- 1 079 667
- EP-A2- 1 349 436
- WO-A-02/51211
- US-A1- 2004 135 522
- US-A1- 2005 029 961

## Beschreibung

Die Erfindung betrifft ein Leuchtensystem, welches mehrere an ein Verteiler- und Kopplerelement angeschlossene Leuchtmittel aufweist.

Es sind Leuchtensysteme bekannt, bei denen mehrere Halogenleuchten parallel an eine zentrale Spannungsquelle angeschlossen werden. Die Spannungsquelle wird hierbei ausreichend dimensioniert, um eine bestimmte Anzahl von Leuchten zu versorgen. Aufgrund des schlechten Lichtwirkungsgrads und einer dadurch entsprechend hohen Wärmeentwicklung bei deren Betrieb und aus Sicherheitsgründen können Halogenleuchten in vielen Einsatzgebieten, wie im Wohn-, Büro-, Küchen- oder Sanitärbereich, mit Leuchtmitteln mit nur jeweils maximal 10 Watt betrieben werden, wodurch die abgegebene Lichtleistung stark beschränkt ist.

In vielen Einsatzbereichen besteht daher, insbesondere seit Verfügbarkeit weißer Leuchtdioden (LEDs) mit akzeptablen Lebensdauern, der Trend zum Ersetzen von Halogenleuchten durch Leuchtdioden-basierte Leuchten, die einen höheren Wirkungsgrad aufweisen. Da (weiße) LEDs jedoch recht hohe Schwankungsbreiten bezüglich ihrer Betriebsspannung (Durchlaßspannung) aufweisen, benötigt man zur Versorgung solcher LEDs mit konstantem Strom geregelte Konstantstromquellen, wobei eine gewisse Anzahl an LEDs bzw. Leuchten mit jeweils einer gewissen Anzahl an LEDs in Reihe an eine zentrale Konstantstromquelle angeschlossen wird bzw. werden. Solche Stromquellen sind schon aus Sicherheitsgründen auf Abgabespannungen von 12 Volt bzw. maximal 48 Volt beschränkt. Bei üblichen Betriebsspannungen weißer LEDs zwischen 3 und 4 Volt sind demnach nur wenige LEDs bzw. Leuchten mit LEDs an eine Stromquelle anschließbar. Zudem wird, wenn eine LED ausfällt, der gesamte Stromkreis unterbrochen, wodurch sämtliche LEDs / Leuchten ausfallen.

Zum Schalten solcher Leuchten werden bei bekannten Systemen üblicherweise ein oder mehrere zentrale, berührungsempfindliche Schalter, insbesondere Wippschalter, oder auch Sensorschalter, verwendet. Ein Integrieren einzelner Schalter in solche Leuchtmittel wird insbesondere bei Halogensystemen allein aufgrund der starken Wärmeentwicklung vermieden oder ist dadurch bedingt nicht möglich.

In der US 2005/0029961 A1 ist eine Schaltungsanordnung zum Betreiben von LEDs gezeigt. In dieser Anordnung sind mehrere LEDs parallel zu einer Spannungsquelle angeordnet, wobei jede LED eine zugeordnete Steuereinheit aufweist.

Aus der US 2004/135522 A1, der EP-A2-1079667 und der WO 02/51211 A sind weitere LED-Systeme bekannt, worin verschiedene Möglichkeiten der Steuerung dieser Systeme behandelt werden.

Es ist Aufgabe der Erfindung, diese Nachteile des Standes der Technik zu überwinden, insbesondere, ein effizientes, flexibel zu betätigendes und leicht skalierbares Leuchtensystem zu schaffen.

Diese Aufgabe wird durch die Merkmale des Anspruchs 1 gelöst.

Vorteilhaft hierbei ist insbesondere, daß durch Integration einer eigenen Stromquelle in jedes Leuchtmittel die einzelnen Leuchtmittel unabhängig voneinander an die Spannungsquelle angeschlossen werden können. Hierdurch wird ermöglicht, daß die jeweiligen Verbindungen zwischen dem Verteiler- und Kopplerelement und jedem daran angeschlossenen Leuchtmittel unbedenkliche Spannungen führen. Zudem fällt bei Ausfall einer der Leuchtdioden zwar das entsprechende Leuchtmittel aus, jedoch bleiben die restlichen Leuchtmittel davon unbeeinflußt. Ferner ist über eine Signalkopplung der einzelnen Leuchtmittel über das Verteiler- und Koppelelement die Möglichkeit gegeben, einzelne, eine Gruppierung oder auch alle Leuchten durch ein Betätigungsmittel, welches einem der Leuchtmittel zugeordnet ist, anzusteuern, also insbesondere an- und auszuschalten.

Das Betätigungsmittel ist dazu eingerichtet, bei dessen Betätigen ein erstes Betätigungssignal an die elektronische Steuereinheit des Betätigungsmittels zu übertragen, und die elektronische Steuereinheit des Leuchtmittels ist dazu eingerichtet, bei Empfang des ersten Betätigungssignals ein Schaltsignal an die Stromquelle zu übertragen, um die Stromquelle ein- oder auszuschalten.

Die elektronische Steuereinheit ist ferner dazu eingerichtet, bei Empfang des ersten Betätigungssignals ein zweites Betätigungssignal an die elektronischen Steuereinheiten weiterer Leuchtmittel zu übertragen, die dazu eingerichtet sind, bei Empfang des zweiten Betätigungssignals ein Schaltsignal an die jeweils zugeordnete Stromquelle zu übertragen, um die Stromquelle ein- oder auszuschalten. Hierdurch kann ein Betätigungssignal, das in einem Leuchtmittel auftritt, an andere / alle Leuchtmittel des Systems weitergegeben werden.

In einer bevorzugten Weiterbildung sind die Leuchtmittel über das Verteil- und Koppelelement parallel an die Spannungsquelle angeschlossen.

Weiterhin sind die Leuchtmittel bevorzugt über das Verteiler- und Kopplerelement zur Signalübertragung miteinander gekoppelt.

Die Leuchtmittel können mit Anschlüssen des Verteiler- und Kopplerelements über mehrpolige Verbindungen verbunden sein. Hierbei können die Verbindungen vorzugsweise dazu eingerichtet sein, die Leuchtmittel mit Spannung zu versorgen und Betätigungssignale von der elektronischen Steuereinheit eines Leuchtmittels an elektronische Steuereinheiten anderer

Leuchtmittel zu übertragen.

Bei einer bevorzugten Weiterbildung der Erfindung sind die Verbindungen vierpolig ausgebildet, wovon zwei Pole zur Spannungsversorgung und die anderen zwei Pole zur synchronen, seriellen Signalübertragung dienen. Die Verbindungen können aber auch dreipolig ausgebildet sein, wovon zwei Pole zur Spannungsversorgung und ein Pol zur asynchronen, seriellen Signalübertragung dienen. Ferner können die Verbindungen auch zweipolig ausgebildet sein, wobei die zwei Pole sowohl zur Spannungsversorgung als auch zur Signalübertragung durch Aufmodulieren dienen.

In einer bevorzugten Weiterbildung der Erfindung sind die Steuereinheiten wenigstens zweier Leuchtmittel dazu eingerichtet, zweite Betätigungssignale per Funk zu übertragen und/oder zu empfangen.

Bevorzugt umfaßt das Betätigungsmittel eine optoelektronische Sensoranordnung, die nach dem Relexlichttasterprinzip arbeitet und eine Leuchtdiode, die einen Lichtmeßstrahl aussendet und in einem lichtdurchlässigen Gehäuse angeordnet ist, sowie ein photosensitives Element aufweist, das im reflektierten Strahlengang der Leuchtdiode angeordnet ist und abhängig von dem reflektierten Lichtmeßstrahl das Betätigungssignal erzeugt. Eine solche Sensoranordnung ist aus der EP 1 383 242 bekannt und bietet den Vorteil, daß zum Ein-/Ausschalten einzelner oder aller Leuchten nur ein Annähern an eine entsprechende Leuchte mit darin integrierter Sensoranordnung notwendig ist, jedoch kein direktes Berühren. Durch diese "dezentrale" Lösung kann auf einen zentral angeordneten Lichtschalter verzichtet werden.

Bevorzugt sendet die Leuchtdiode einen Lichtmeßstrahl im infraroten Spektralbereich aus.

In einer bevorzugten Weiterbildung weist wenigstens ein Leuchtmittel mehrere Leuchtdioden auf, die in Reihe mit der zugeordneten Stromquelle verbunden sind.

Bevorzugt umfaßt wenigstens ein Leuchtmittel ferner einen mit der elektronischen Steuereinheit des Leuchtmittels gekoppelten Sensor zum Bestimmen der Umgebungstemperatur, wobei die elektronische Steuereinheit bewirkt, daß der von der Stromquelle abgegebene Strom bei Überschreiten einer Temperaturschwelle verringert wird, um ein Überhitzen der mit der Stromquelle verbundenen Leuchtdioden zu verhindern.

Ein Ausführungsbeispiel der Erfindung ist anhand der Zeichnungen im folgenden mit weiteren Einzelheiten näher erläutert. Es zeigen:
Fig. 1 ein erfindungsgemäßes Leuchtensystem mit mehreren Leuchtmitteln, die jeweils über eines der beiden gezeigten Verteiler- und Kopplerelemente an eine Spannungsquelle angeschlossen sind;
Fig. 2 ein Leuchtmittel mit mehreren Leuchtdioden und einem Betätigungsmittel; und
Fig. 3 ein Leuchtmittel mit mehreren Leuchtdioden und einem Temperatursensor, ohne Betätigungsmittel.

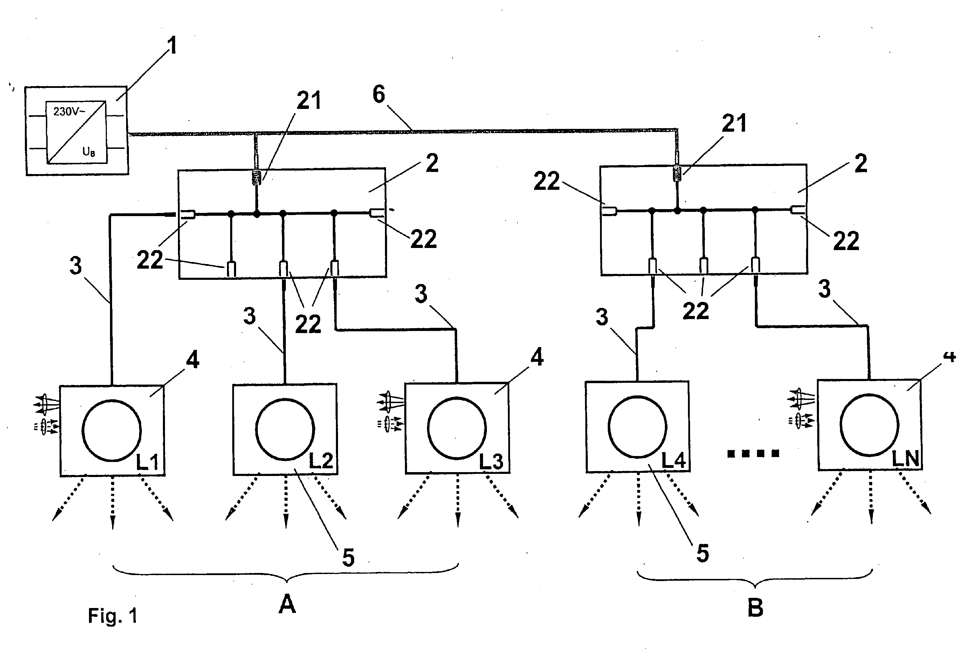

Das in Fig. 1 gezeigte Leuchtensystem umfaßt eine Spannungsquelle 1 und zwei Verteiler-und Kopplerelemente 2, die zueinander parallel an die Spannungsquelle 1 über eine mehrpolige Verbindungsleitung 6 angeschlossen sind. Die mehrpolige Verbindungsleitung 6 ermöglicht neben der Spannungsversorgung das Übertragen von Signalen zwischen den einzelnen Verteiler- und Kopplerelementen.

An jedes Verteiler- und Kopplerelement sind mehrere Leuchtmittel 4 oder 5 über jeweils eine mehrpolige Verbindung 3 zur Spannungsversorgung und zur Signalübertragung angeschlossen. Hierdurch sind die Leuchtmittel 4, 5 über das Verteiler- und Kopplerelement 2 parallel zueinander an die Spannungsquelle 1 angeschlossen. Ferner ist jedes Leuchtmittel 4, 5 über das Verteiler- und Kopplerelement 2 mit allen anderen an das gleiche Verteiler- und Kopplerelement 2 angeschlossenen Leuchtmitteln 4, 5 zur Signalübertragung gekoppelt.

Jedes Verteiler- und Kopplerelement weist einen mehrpoligen Anschluß 21 zur Anbindung an die Verbindungsleitung 6 und mehrere mehrpolige Anschlüsse 22 auf, über die die einzelnen Leuchtmittel 4, 5 mit dem Verteiler- und Kopplerelement 2 verbunden werden. Die Anschlüsse 22 sind parallel zueinander an den Anschluß 21 sowie untereinander gekoppelt. Hierzu sind einander entsprechende Pole der Anschlüsse 22 und des Anschlusses 21 sowie der Anschlüsse 22 untereinander zur Spannungsversorgung und / oder zur Signalübertragung miteinander gekoppelt.

In der in Fig. 1 gezeigten Ausführungsform sind die Anschlüsse 22 und Verbindungen 3 jeweils vierpolig und der Anschluß 21 und die Verbindungsleitung 6 zweipolig ausgebildet. Hierbei dienen zwei Pole der Anschlüsse 22 und der Verbindungen 3 zur Spannungsversorgung und die anderen beiden Pole zur synchronen seriellen Signalübertragung zwischen den Leuchtmitteln 4, 5. Alternativ können die Anschlüsse 22 und die Verbindungen 3 auch drei-oder zweipolig ausgebildet sein, mit entweder nur einem Pol zur asynchronen seriellen Datenübertragung oder durch gleichzeitiges Verwenden der beiden Spannungspole zum Aufmodulieren der zu übertragenden Signale (Powerline-Übertragungsverfahren).

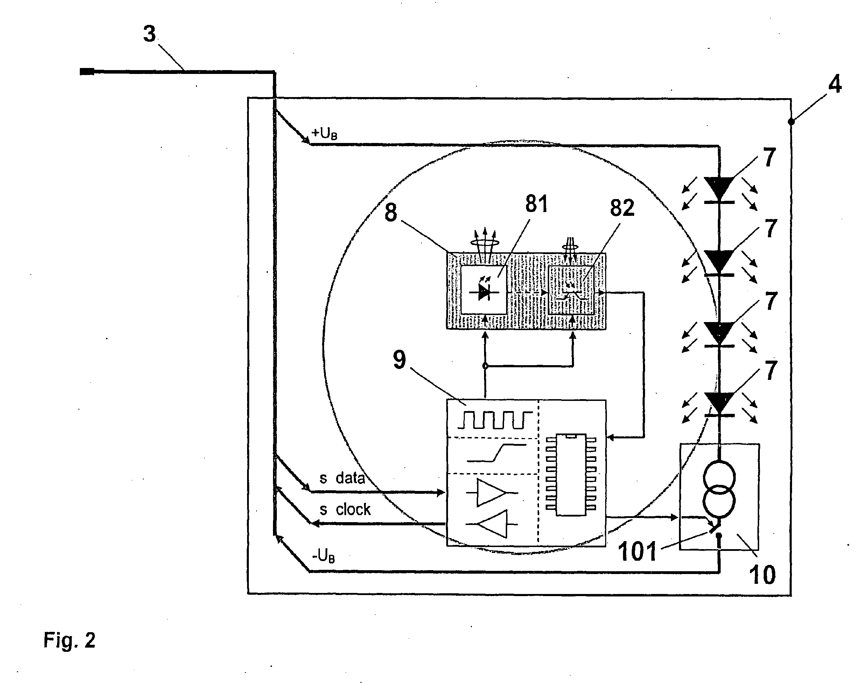

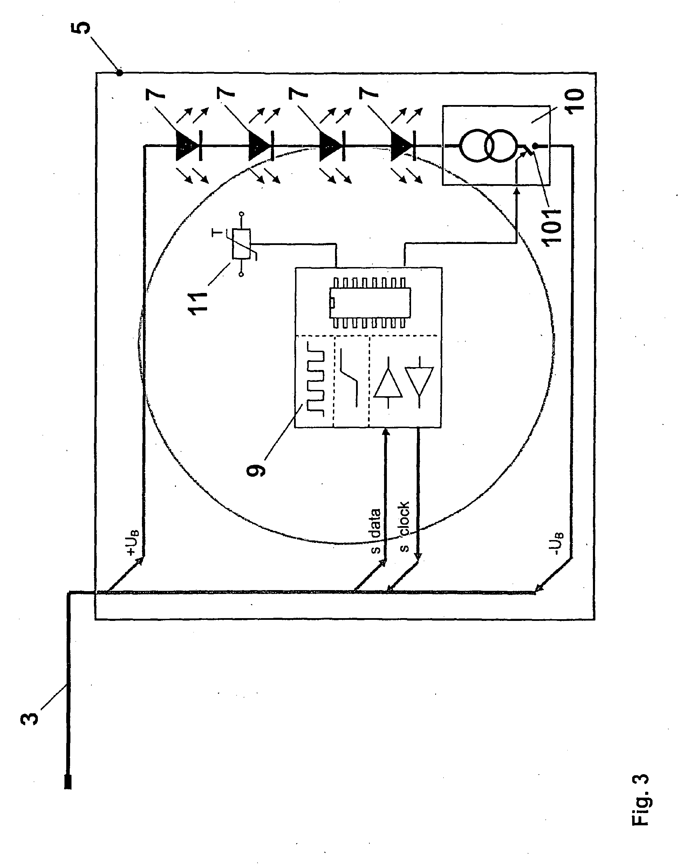

Die in Fig. 1 gezeigten Leuchtmittel 4, 5 umfassen sowohl Leuchtmittel 4 mit einem Betätigungsmittel 8, wie in Fig. 2 gezeigt, als auch Leuchtmittel 5 ohne Betätigungsmittel, wie in Fig. 3 gezeigt.

Das in Fig. 2 gezeigte Leuchtmittel 4 umfaßt eine steuerbare, über die Verbindung 3 mit Spannung versorgte Stromquelle 10. Ferner umfaßt das Leuchtmittel 4 vier Leuchtdioden 7, die in Reihe mit der Stromquelle 10 verbunden sind. In der gezeigten Ausführungsform werden weiße Leuchtdioden verwendet, die mit einem Strom von etwa 350 mA betrieben werden. Die Stromquelle 10 weist ferner ein Schaltelement 101 zum Ein- und Ausschalten derselben auf.

Wie zudem in Fig. 2 gezeigt ist, umfaßt das Leuchtmittel 4 ein Betätigungsmittel 8 und eine elektronische Steuereinheit 9. Das Betätigungsmittel 8 ist als eine optoelektronische Sensoranordnung ausgebildet, die nach dem Reflextasterprinzip arbeitet, und eine Leuchtdiode 81, die einen Lichtmeßstrahl aussendet und in einem lichtdurchlässigen Gehäuse angeordnet ist, sowie ein photosensitives Element 82 aufweist, das im reflektierten Strahlengang der Leuchtdiode 81 angeordnet ist und abhängig von dem reflektierten Lichtmeßstrahl ein erstes Betätigungssignal erzeugt. Die Leuchtdiode 81 sendet hierzu einen Lichtmeßstrahl im infraroten Spektralbereich aus, um sich von dem Spektrum der weißen Leuchtdioden 7 abzugrenzen. Das Betätigungsmittel 8 ist zudem mit der elektronischen Steuereinheit 9 derart gekoppelt, daß die elektronische Steuereinheit die Leuchtdiode 81 des Betätigungsmittels 8 ansteuern kann. In Abhängigkeit von dem detektierten Ausgangssignal des photosensitiven Elements (d.h. bei Empfang eines Betätigungssignals) steuert die elektronische Steuereinheit das Schaltelement 101 der steuerbaren Stromquelle 10 an, wodurch die Stromquelle ein- oder ausgeschaltet wird. Alternativ kann durch Ansteuern des Elements 101 z.B. auch eine Dimmerfunktion oder eine andere, zeitliche Veränderung der Helligkeit einzelner, einer Gruppe oder aller Leuchtdioden erzielt werden.

Die elektronische Steuereinheit 9 ist mit zwei Signalleitungen der Verbindung 3 zur synchronen, seriellen Datenübertragung gekoppelt. Hierüber kann die elektronische Steuereinheit 9 bei Empfang des ersten Betätigungssignals ein zweites Betätigungssignal an die elektronischen Steuereinheiten weiterer Leuchtmittel 4, 5 übertragen oder ein zweites Betätigungssignal empfangen. Bei Empfang eines zweiten Betätigungssignals überträgt die jeweils empfangende elektronische Steuereinheit 9 ein Ansteuersignal an das Schaltelement 101 der jeweils zugeordneten Stromquelle 10, um die Stromquelle 10 ein- oder auszuschalten (oder, wie oben erwähnt, zu dimmen, etc.). Der Empfang des zweiten Betätigungssignals löst in der Regel dieselbe Funktion aus wie der Empfang des ersten Betätigungssignals von dem zugeordneten Betätigungsmittel 8.

Das in Fig. 3 gezeigte Leuchtmittel 5 entspricht im wesentlichen dem in Fig. 2 gezeigten Leuchtmittel 4, weist jedoch kein zugeordnetes Betätigungsmittel 8, jedoch einen Temperatursensor 11 auf.

In der in Fig. 1 gezeigten Anordnung sind mehrere der in den Fig. 2 und 3 dargestellten Leuchtmittel 4, 5 zu sehen, die jeweils mit einer Kennzeichnung L1 ... LN versehen sind. Die Leuchtmittel L1-L3 gehören hierbei zu einer Gruppierung A und sind an das erste Verteiler-und Kopplerelement 2 angeschlossen. Die Leuchtmittel L4-LN gehören zu einer Gruppierung B und sind an das zweite Verteiler- und Kopplerelement 2 angeschlossen. Bei Betätigen des Betätigungsmittels 8 des Leuchtmittels L1 wird ein erstes Betätigungssignal an die elektronische Steuereinheit 9 des Leuchtmittels L1 übertragen, woraufhin diese ein Schaltsignal an die Stromquelle 10 des Leuchtmittels L1 überträgt. Durch dieses Schaltsignal wird z.B. die Stromquelle 10 des ersten Leuchtmittels L1, und somit die daran angeschlossenen Leuchtdioden 7, eingeschaltet. Weiterhin überträgt die elektronische Steuereinheit 9 des ersten Leuchtmittels L1 ein zweites Betätigungssignal an die jeweilige elektronische Steuereinheit 9 der Leuchtmittel L2 und L3 über die Verbindungen 3 und das Verteiler- und Kopplerelement 2. Die elektronischen Steuereinheiten 9 der Leuchtmittel L2, L3 übertragen wiederum bei Empfang des zweiten Betätigungssignals ein Schaltsignal an die jeweils zugeordneten Stromquellen 10, wodurch diese Stromquellen und die damit verbundenen Leuchtdioden ebenfalls eingeschaltet werden. Somit können durch Betätigen des dem Leuchtmittel L1 zugeordneten Betätigungsmittels 8 alle in dieser Gruppierung A enthaltenen Leuchtmittel L1, L2, L3 geschaltet werden.

Das Leuchtmittel L3 der Gruppierung A weist ebenfalls ein Betätigungsmittel 8 auf, wobei in der oben beschriebenen Weise die elektronische Steuereinheit 9 des Leuchtmittels L3 bei Betätigen dessen Betätigungsmittels 8 ein zweites Betätigungssignal an die jeweiligen elektronischen Steuereinheiten 9 der Leuchtmittel L1 und L2 überträgt. Jedoch ist in diesem Beispiel dem Leuchtmittel L2 kein Betätigungsmittel zugeordnet, so daß das Leuchtmittel L2 nur immer durch Betätigen des Betätigungsmittels 8 des Leuchtmittels L1 oder L3 geschaltet wird.

Die an einem Verteiler- und Kopplerelement 2 angeschlossenen Leuchtmittel können bei Betätigen eines der Betätigungsmittels, das einem der Leuchtmittel in dieser Gruppierung zugeordnet ist, also in jeder gewünschten Kombination angesteuert und insbesondere geschaltet werden. Zudem können über die Leitung 6 auch ausgewählte oder alle Leuchtmittel der Gruppierung B, durch Betätigen eines Betätigungsmittels eines der Leuchtmittel der Gruppierung A angesteuert werden (adressierbare Leuchtmittel).

Vorzugsweise weist jedes der in Fig. 1 gezeigten Leuchtmittel 4, 5 einen mit der elektronischen Steuereinheit 9 des jeweiligen Leuchtmittels gekoppelten Temperatursensor 11 (nur gezeigt in Fig 3,) auf. Das Ausgangssignal des Sensors wird von der elektronischen Steuereinheit 9 des Leuchtmittels ausgelesen und dient zum Bestimmen der unmittelbaren Umgebungstemperatur des jeweiligen Leuchtmittels und insbesondere der Leuchtdioden 7. Sollte hierbei eine bestimmte Temperaturschwelle überschritten werden, wird ein entsprechendes Steuersignal von der elektronischen Steuereinheit an die zugeordnete Stromquelle gesendet, wodurch der abgegebene Strom der Stromquelle 10 verringert wird, um ein Überhitzen der Leuchtdioden 7 zu verhindern. Alternativ kann auch nur ein einziges oder eine Gruppe von Leuchtmitteln einen solchen Sensor aufweisen. Zudem können auch die detektierten Temperaturmeßwerte über die Signalkopplung zwischen den einzelnen Leuchtmitteln ausgetauscht werden und zur Helligkeitssteuerung in dem System verwendet werden.

Schließlich soll noch darauf hingewiesen werden, daß die Leuchtdioden 7 auch farbige Leuchtdioden umfassen können, und daß die Signalübertragung von zweiten Betätigungssignalen zwischen den elektronischen Steuereinheiten verschiedener Leuchtmittel auch per Funk geschehen kann.

Die in der vorliegenden Beschreibung, den Ansprüchen und den Figuren offenbarten Merkmale können sowohl einzeln als auch in beliebiger Kombination für die Verwirklichung der Erfindung in ihren verschiedenen Ausgestaltungen von Bedeutung sein.

## Patentansprüche

1. Leuchtensystem, welches umfaßt
wenigstens ein Verteiler- und Kopplerelement (2), das mit einer Spannungsquelle (1) verbunden ist;
mehrere Leuchtmittel (4, 5), wovon jedes mit dem Verteiler- und Kopplerelement verbunden ist und ferner umfaßt
- eine steuerbare Stromquelle (10);
- wenigstens eine Leuchtdiode (7), die mit der Stromquelle verbunden ist;
- eine elektronische Steuereinheit (9) zur Steuerung des von der Stromquelle abgegebenen Stroms;
wobei wenigstens eines der Leuchtmittel (4, 5) ein zugeordnetes Betätigungsmittel (8) aufweist, das mit der elektronischen Steuereinheit (9) gekoppelt ist, um bei Betätigen des Betätigungsmittels die Stromquelle wenigstens eines Leuchtmittels anzusteuern, **dadurch gekennzeichnet, dass** ein erstes Leuchtmittel (4) ein zugeordnetes Betätigungsmittel (8) und ein zweites Leuchtmittel (5) kein Betätigungsmittel aufweisen,
das Betätigungsmittel (8) dazu eingerichtet ist, bei dessen Betätigen ein erstes Betätigungssignal an die elektronische Steuereinheit (9) des ersten Leuchtmittel (4) zu übertragen,
die elektronische Steuereinheit (9) des ersten Leuchtmittels (4) dazu eingerichtet ist, bei Empfang des ersten Betätigungssignals ein Schaltsignal an die Stromquelle (10) des ersten Leuchtmittels und ein zweites Betätigungssignal an die elektronische Steuereinheit (9) des zweiten Leuchtmittels (5) zu übertragen, und
die elektronischen Steuereinheit (9) des zweite Leuchtmittels (5) dazu eingerichtet ist, bei Empfang des zweiten Betätigungssignals ein Schaltsignal an die Stromquelle (10) des zweiten Leuchtmittels zu übertragen,
so daß durch Betätigen des dem ersten Leuchtmittel zugeordneten Betätigungsmittels das erste und das zweite Leuchtmittel angesteuert werden.

2. System nach einem der vorhergehenden Ansprüche, wobei
die Leuchtmittel über das Verteiler- und Kopplerelement (2) parallel an die Spannungsquelle (1) angeschlossen sind.

3. System nach einem der vorhergehenden Ansprüche, wobei
die Leuchtmittel über das Verteiler- und Kopplerelement (2) zur Signalübertragung miteinander gekoppelt sind.

4. System nach einem der vorhergehenden Ansprüche, wobei
die Leuchtmittel (4, 5) mit Anschlüssen des Verteiler- und Kopplerelements (2) über mehrpolige Verbindungen (3) verbunden sind.

5. System nach Anspruch 4, wobei
die Verbindungen (3) dazu eingerichtet sind, die Leuchtmittel mit Spannung zu versorgen und Betätigungssignale von der elektronischen Steuereinheit (9) eines Leuchtmittels (4) an elektronische Steuereinheiten anderer Leuchtmittel (4, 5) zu übertragen,

6. System nach Ansprüch 5, wobei
die Verbindungen (3) vierpolig ausgebildet sind, wovon zwei Pole zur Spannungsversorgung und die anderen zwei Pole zur synchronen seriellen Signalübertragung dienen.

7. System nach Anspruch 5, wobei
die Verbindungen (3) dreipolig ausgebildet sind, wovon zwei Pole zur Spannungsversorgung und ein Pol zur asynchronen seriellen Signalübertragung dienen.

8. System nach einem der Ansprüche 5, wobei
die Verbindungen (3) zweipolig ausgebildet sind und die zwei Pole sowohl zur Spannungsversorgung als auch zur Signalübertragung durch Aufmodulieren dienen.

9. System nach Anspruch 1, 2 oder 4, wobei
die Steuereinheiten (9) wenigstens zweier Leuchtmittel (4, 5) dazu eingerichtet sind, zweite Betätigungssignale per Funk zu übertragen und / oder zu empfangen.

10. System nach einem der vorhergehenden Ansprüche, wobei das Betätigungsmittel (8) eine optoelektronische Sensoranordnung umfaßt, die nach dem Reflexlichttasterprinzip arbeitet und eine Leuchtdiode (81), die einen Lichtmeßstrahl aussendet und in einem lichtdurchlässigen Gehäuse angeordnet ist, sowie ein fotosensitives Element (82) aufweist, das im reflektierten Strahlengang der Leuchtdiode (81) angeordnet ist und abhängig von dem reflektierten Lichtmessstrahl das Betätigungssignal erzeugt.

11. System nach Anspruch 10, wobei
die Leuchtdiode (81) einen Lichtmeßstrahl im infraroten Spektralbereich aussendet.

12. System nach einem der vorhergehenden Ansprüche, wobei
wenigstens ein Leuchtmittel (4, 5) mehrere Leuchtdioden (7) aufweist, die in Reihe mit der zugeordneten Stromquelle (10) verbunden sind.

13. System nach einem der vorhergehenden Ansprüche, wobei
wenigstens ein Leuchtmittel (4, 5) ferner einen mit der elektronischen Steuereinheit (9) des Leuchtmittels gekoppelten Sensor (11) zum Bestimmen der Umgebungstemperatur umfaßt und die elektronische Steuereinheit bewirkt, daß der von der Stromquelle (10) abgegebene Strom bei Überschreiten einer Temperaturschwelle verringert wird, um ein Überhitzen der Leuchtdioden (7) zu verhindern.

## Claims

1. Light system comprising:
at least one distributor and coupler element (2), connected to a voltage source (1);
a plurality of illuminants (4, 5) each of which is connected to said distributor and coupler element and comprises:
- a controllable current source (10);
- at least one light diode (7) connected to the current source;
- an electronic control unit (9) for controlling the current supplied by said current source;
where at least one of said illuminants (4, 5) comprises an associated actuating means (8),
said actuating means being coupled to the electronic control unit (9), for controlling the current source of at least one illuminant upon actuation of the actuation means,
**characterized in that** a first illuminant (4) comprises an associated actuating means (8) and a second illuminant (5) comprises no actuating means,
the actuating means (8) is configured to transmit a first actuation signal to the electronic control unit (9) of the first illuminant (4) upon actuation thereof,
the electronic control unit (9) of the first illuminant (4) is configured to transmit a switching signal to the current source (10) of the first illuminant and a second actuating signal to the electronic control unit (9) of the second illuminant (5) when receiving said first actuating signal, and
the electronic control unit (9) of the second illuminant (5) is configured to transmit a switching signal to the current source (10) of the second illuminant when receiving the second actuating signal,
so that, upon actuation of the actuating means associated with the first illuminant, the first and second illuminants are driven.

2. System according to one of the proceeding claims, wherein the illuminants are connected in parallel to the voltage source (1) via the distributor and coupler element (2).

3. System according to one of the proceeding claims, wherein the illuminants are coupled to each other for signal transmission via the distributor and coupler elements (2).

4. System according to one of the proceeding claims, wherein the illuminants (4, 5) are connected to terminals of the coupler and distributor element (2) via multi-pole connections (3).

5. System according to claim 4, wherein the connections (3) are configured to supply the illuminants with voltage and to transmit the actuation signal from the electronic control unit (9) of a illuminant (4) to the electronic control unit of another illuminant (4, 5).

6. System according to claim 5, wherein the connections (3) are quadri-polar wherein two poles are used for voltage supply and the other two poles are used for synchronous serial signal transmission.

7. System according to claim 5, wherein the connections (3) are tri-polar wherein two poles are used for voltage supply and one pole is used for asynchronous serial signal transmission.

8. System according to claim 5, wherein the connections (3) are bipolar wherein the two poles are used both for voltage supply as well as for signal transmission using modulation.

9. System according to claim 1, 2 or 4, wherein
the control units (9) of at least two illuminants (4, 5) are configured to transmit and/or to receive the second actuating signal via radio transmission.

10. System according to one of the proceeding claims wherein said actuating means (8) comprises an opto-electronic sensor assembly which operates according to the reflex light switch principle and comprises a light diode (81) emitting a light measurement beam and being arranged in a translucent housing, and a photosensitive element (82) which is arranged in the reflected beam path of the light diode (81) and which generates the actuating signal in response to the reflected light measurement beam.

11. System according to claim 10, wherein the light diode (81) sends a light measurement beam in the infrared spectral range.

12. System according to one of the proceeding claims, wherein at least one illuminant (4, 5) comprises a plurality of light diodes (7) which are connected in series to the associated current source (10).

13. System according to one of the proceeding claims, wherein at least one illuminant (4, 5) further comprises a sensor (11) for determining the ambient temperature, the sensor being coupled with the electronic control unit (9) of the illuminant, and wherein the electronic control unit causes the current supplied by the current source (10) to be lowered when a temperature threshold is exceeded to avoid overheating of the light diodes (7).

## Revendications

1. Système d'éclairage, qui comprend
au moins un élément répartiteur et coupleur (2), qui est relié à une source de tension (1),
plusieurs moyens d'éclairage (4, 5), dont chacun est relié à l'élément répartiteur et coupleur et comprend également
- une source de courant (10) contrôlable ;
- au moins une diode électroluminescente (7), qui est reliée à la source de courant,
- une unité de commande électronique (9) pour la commande du courant émis par la source de courant ;
au moins l'un des moyens d'éclairage (4, 5) présentant un moyen d'actionnement (8) associé, qui est couplé avec l'unité de commande (9) électronique, afin d'actionner la source de courant d'au moins un moyen d'éclairage en cas d'actionnement du moyen d'actionnement, **caractérisé en ce qu'**un premier moyen d'éclairage (4) présente un moyen d'actionnement (8) associé et un second moyen d'éclairage (5) ne présente pas de moyen d'actionnement,
le moyen d'actionnement (8) est équipé pour transférer, lors de son actionnement, un premier signal d'actionnement à l'unité de commande (9) électronique du premier moyen d'éclairage (4),
l'unité de commande (9) électronique du premier moyen d'éclairage (4) est équipé pour transmettre, à la réception du premier signal d'actionnement, un signal de commutation à la source de courant (10) du premier moyen d'éclairage et un second signal d'actionnement à l'unité de commande (9) électronique du second moyen d'éclairage (5), et
l'unité de commande (9) électronique du second moyen d'éclairage (5) est équipé pour transmettre, à la réception du second signal d'actionnement, un signal de commutation à la source de courant (10) du second moyen d'éclairage,
de sorte que le premier et le second moyen d'éclairage sont commandés par l'actionnement du moyen d'actionnement associé au premier moyen d'éclairage.

2. Système selon l'une quelconque des revendications précédentes,
les moyens d'éclairage étant raccordés via l'élément répartiteur et coupleur (2) parallèlement à la source de tension (1).

3. Système selon l'une quelconque des revendications précédentes,
les moyens d'éclairage étant couplés l'un à l'autre via l'élément répartiteur et coupleur (2) pour la transmission de signal.

4. Système selon l'une quelconque des revendications précédentes,
les moyens d'éclairage (4, 5) étant reliés à des branchements de l'élément répartiteur et coupleur (2) par l'intermédiaire de liaisons (3) multipolaires.

5. Système selon la revendication 4,
les liaisons (3) étant équipées pour alimenter les moyens d'éclairage en tension et transmettre des signaux d'actionnement de l'unité de commande (9) électronique d'un moyen d'éclairage (4) à des unités de commande électroniques d'autres moyens d'éclairage (4, 5).

6. Système selon la revendication 5,
les liaisons (3) étant conçues quadripolaires, dont deux pôles servent à l'alimentation en tension et les deux autres pôles à la transmission de signal série synchrone.

7. Système selon la revendication 5,
les liaisons (3) étant conçues tripolaires, dont deux pôles servent à l'alimentation en tension et un pôle à la transmission de signal série asynchrone.

8. Système selon l'une quelconque des revendications 5,
les liaisons (3) étant conçues bipolaires et les deux pôles servant aussi bien à l'alimentation en tension qu'à la transmission de signal par surmodulation.

9. Système selon la revendication 1, 2 ou 4,
les unités de commande (9) d'au moins deux moyens d'éclairage (4, 5) étant équipées pour transmettre et/ou recevoir des seconds signaux d'actionnement par radio.

10. Système selon l'une quelconque des revendications précédentes, le moyen d'actionnement (8) comprenant un dispositif capteur optoélectronique, qui travaille selon le principe du capteur optique à réflexion et une diode électroluminescente (81), qui émet un faisceau de mesure de lumière et est disposé dans un boîtier perméable à la lumière, ainsi qu'un élément (82) photosensible, qui est disposé dans la trajectoire de faisceau réfléchi de la diode électroluminescente (81) et génère le signal d'actionnement en fonction du faisceau réfléchi de mesure de lumière.

11. Système selon la revendication 10,
la diode électroluminescente (81) émettant un faisceau de mesure de lumière dans la zone spectrale infrarouge.

12. Système selon l'une quelconque des revendications précédentes,
au moins un moyen d'éclairage (4, 5) présentant plusieurs diodes électroluminescentes (7) qui sont reliées en série avec la source de courant (10) associée.

13. Système selon l'une quelconque des revendications précédentes,
au moins un moyen d'éclairage (4, 5) comprenant également un capteur (11) couplé à l'unité de commande (9) électronique du moyen d'éclairage pour la détermination de la température ambiante et l'unité de commande électronique ayant pour effet que le courant émis par la source de courant (10) est réduit en cas de dépassement d'un seuil de température, afin d'empêcher une surchauffe des diodes électroluminescentes (7).
